# EUROPEAN PATENT SPECIFICATION

(11) **EP 0 711 712 B1**
(45) Date of publication and mention of the grant of the patent: **16.06.1999**
(21) Application number: 94117305.6
(22) Date of filing: 03.11.1994
(51) Int. Cl.: B65D 73/02, H05K 13/00

(54) **Tape and reel packaging system for single-in-line electronic circuits**
Band-und-Spule-Verpackungssystem für single-in-line elektronische Schaltungen
Système d'emballage de bandes et bobines pour circuits électroniqes à connexions en ligne

(43) Date of publication of application: 15.05.1996
(73) Proprietor: ELECTROMAG N.V., 9600 Ronse (BE)
(72) Inventor: Deschamps, Jean Marie, B-7540 Kain (BE); Bauwens, Lucien, B-9680 Maarkedal (BE); Vincent, Eddy, B-9620 Zottegem (BE)

(56) References cited:
- US-A- 3 029 939
- US-A- 3 133 637
- US-A- 3 906 614
- US-A- 4 411 362

## Description

### Field of the invention:

This invention relates in general to a tape and reel packaging system for single-in-line electronic circuits, having particular utilization in the field of automated pick and place unit. It relates more specifically to a packaging system that is environmentally friendly because it only uses basic materials that are biodegradable. It provides storage for said components in a horizontal position on the reel, thereby assuring the mechanical protection of the units and achieving the maximum packaging density.

The invention further provides an easy method for assembling the circuits into the reel. The invention more specifically comprises a perforated paper carrier tape on which the circuits to be stored and transported are positioned in predeterminated locations and are maintained in these locations by means of an adhesive bonding tape, securing the fixation of the circuits during transportation. The invention also relates to apparatus designed for manipulation of the packaging system in such a way that the circuits are presented in an upright position at the pick and place unit of an automated component assembly equipment, thereby guaranteeing a smooth and easy release of the circuits from the packaging system.

### Background of the invention:

Electronic circuits very frequently incorporate many differently shaped components which are assembled by means of highly automated machinery. These electronic circuits are then furtheron assembled into a finished product unit. From an economic standpoint here too it is highly desirable to automate as much as possible these assembly operations. To be able to do so, mechanisms and equipment must be available enabling the mechanized delivery of these components at the pick and place robotized head of an automated assembly equipment, allowing the assembly of such circuits into a finished product unit.

A large number of such packaging systems and assembly machinery have thus been developed in the past with very large success for leadless components such as capacitors, resistors, diodes, integrated circuits and transistors in surface mount design. Much more limited success has been reached for packaging circuits with leads or terminals into a similar system ready for automated processing into finished product units.

Because of the very fragile nature of these terminals, handling of such components may easily cause bending of one or more of these leads, thereby deteriorating lead coplanarity and originating problems at insertion of the component into a further subassembly that are difficult to overcome. Such problems can originate frequent machine stops of the automated equipment and result in defective subassemblies. Packaging systems have been developed that have eliminated the above problem and still allow presentation of the components at the pick and place workstations in their application to subassemblies. A previously patented example of such a packaging system has been disclosed in U.S. patent N° 4,583,641 granted April 22, 1986 to John R. Gelzer and was further developed in U.S. patent N° 5,312,015 granted May 17, 1994 to the same inventor. That prior art packaging system consisted of an elongated plastic carrier tape to which a secondary plastic packaging tape was removably secured and the two tapes cooperatively retained said articles in loop-form assemblies. The plastic packaging tape was mechanically interconnected to the plastic carrier tape by means which enabled the two tapes to be readily separated from each other at the assembly point, thereby releasing said article for pick and place operations.

Obvious drawbacks of the above described system are the necessity for very specific equipment to make possible taping and reeling of said components and also for same specific equipment to allow releasing of said components at the pick & place workstations. Furthermore this complex packaging system requires state-of-the art handling equipment. Besides, at the point were the two tapes are mechanically separated, lots of plastic materials are accumulated that have proven to be difficultly reusable, but on the contrary are simply disposed off as waste.

According to US-A-3 906 614 electrical components are positioned almost horizontally on a carrier tape, wherein lead terminals of the components protrude through through-holes of the carrier tape.

### Summary of the invention

In accordance with this invention, a packaging system is provided that is capable of accepting electrical components with single in-line type electrodes and to provide protection for those components subsequent to their utilization in an automated assembly line. In contrast to the prior art according to US-A-4 583 641 and US-A-5 312 015 however, the latter system offers a much easier concept of packaging, utilising for example biodegradable paper materials, and not requiring very sophisticated and expensive handling apparatus.

The packaging system of this invention as defined in claim 1 includes a carrier tape, which is perforated at repeatedly spaced distances allowing insertion of the components lead terminals by means of a simple insertion tool. Once inserted into the carrier tape, said electronic circuits are firmly secured in place by means of an adhesive tape allowing fixation of the lead terminals onto the back of the carrier tape. Upon advancing this packaging system during the 'reeling process,' said electronic circuits automatically switch from a vertical position at insertion into the carrier tape, to a horizontal position, at reeling, thereby ensuring an optimal packaging density of the assembled reel. At the same time the mechanical protection of the parts is guaranteed. The reels are typically made out of standard cardboard raw materials.

An advantage of this packaging system is that is retains the electronic circuits in the desired orientation that is compatible with automated apparatus at the pick and place workstation of the automated assembly line. However, despite the fact that said electronic circuits lie in horizontal position on the packaged reel, they readily return into a precise vertical upright position at unreeling by means of a simple tooling typically designed for this purpose. Therefore, in accordance with this invention, specific apparatus is provided for effecting manipulation of the carrier tape in such a way to release the electronic circuits from the adhesive tape, thereby returning said components into an upright position, allowing easy pick-up either manually or at the robotized pick and place system of the automated assembly machine, without the need for specific tooling or equipment. In the illustrative embodiment of this apparatus, a simple feeder unit is described in order to allow said electronic components to return from their horizontal position on the reel into a vertical upright position typically needed at the pick & place workstation.

Obviously the horizontal position of said electronic components on the reel offers superior protection against damage of the lead terminals or deterioration of the lead coplanarity compared to prior art systems whereby said components are transported in a vertical position. The article packaging system of this invention is of particular utility because it only uses biodegradable basic raw materials thereby ensuring a much lower environmental threat with respect to production of waste.

These and other objects and advantages of the invention will be readily apparent from the following detailed description of illustrative embodiments of the invention and the accompanying drawings thereof.

### Description of the drawing figures

- Fig. 1: is a perspective view of a single-in-line (SIL) electronic circuit.
- Fig. 2: is a fragmentary sectional view of a SIL circuit with straight lead terminals.
- Fig. 3: is a fragmentary sectional view of a SIL circuit with snap-in lead terminals
- Fig. 4: is a fragmentary perspective view of a length of the packaging system embodying this invention and including a carrier tape and an adhesive tape partially assembled with SIL electronic circuits.
- Fig. 5: is a fragmentary enlarged view of a grid hole in Fig. 4.
- Fig. 6: is a diagrammatic illustration of the mechanical components for effecting automated reel taping of said SIL circuits using the packaging system of this invention.
- Fig. 7: is a fragmentary sectional view taken along a plane defined by line A-A in Fig. 4.
- Fig. 8: is a front and side view of an assembled reel using the packaging system of this invention.
- Fig. 9: is a diagrammatic illustration of the mechanical components for affecting automatic unreeling of said SIL circuits at the pick and place workstation of an automated assembly equipment.

### Description of the illustrative embodiment of the invention

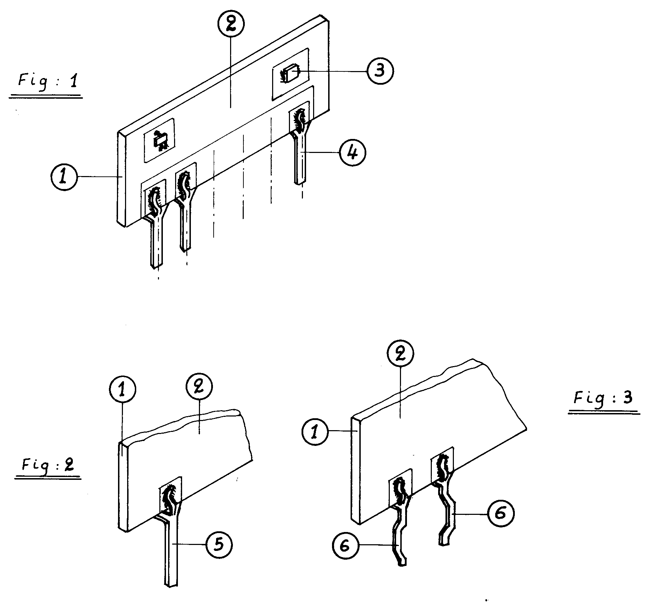

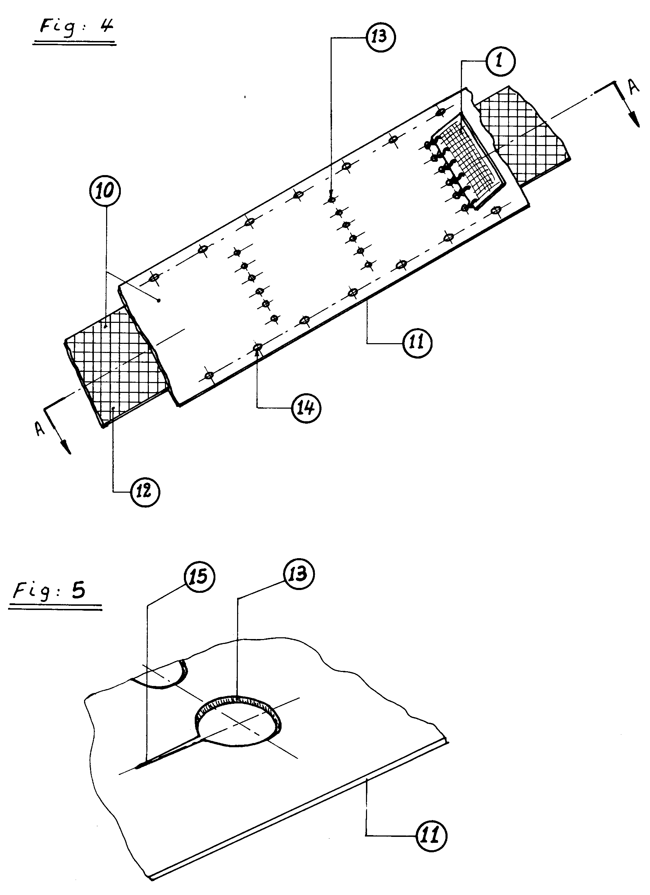

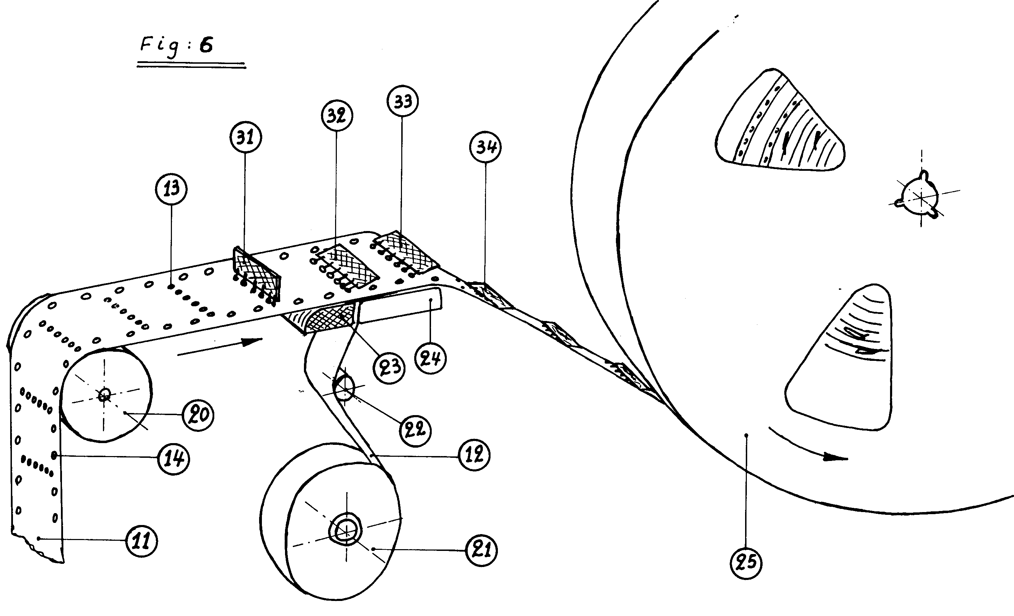

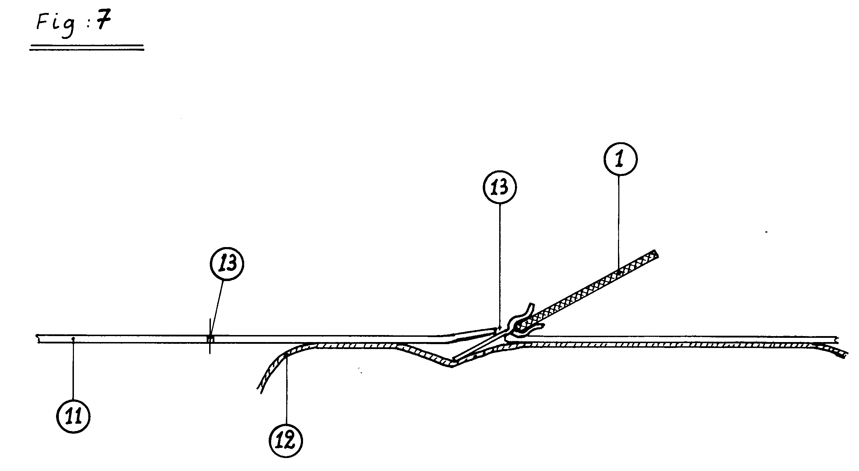

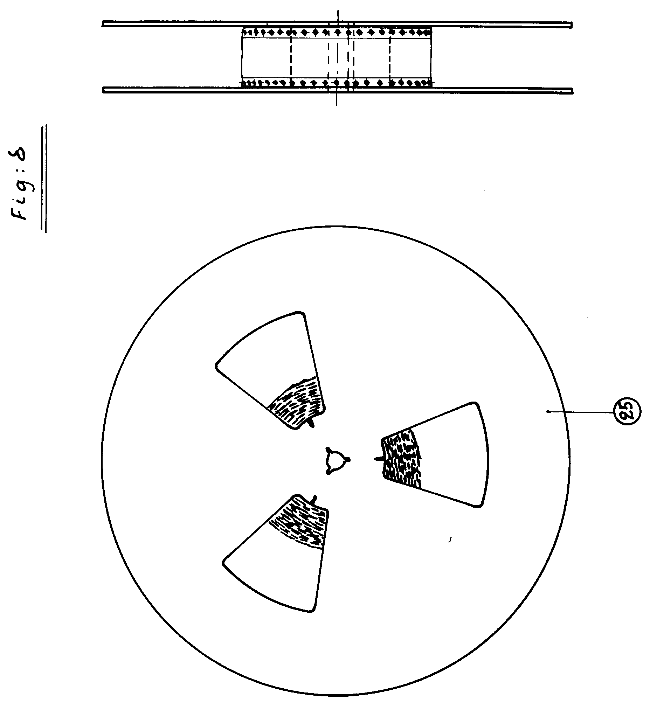

Referring to Fig. 1, a single-in-line electronic circuit **1**, hereafter called SIL circuit, is composed of a basic substrate **2** carrying the different electronic functions, carrying eventually add-on components **3** and a plurality of lead terminals **4.**

These lead terminals all are grouped on one lateral side of said substrate, therefore called single-in-line circuits.

Lead spacings, often called grid, typically are 100 microns or 2.54 mm and the number of terminals can vary from 2 to n, n being a integer number higher than 2. Although lead spacings of 100 microns are described as being typical, it will be understood that other lead spacings may be utilised.

In some specified applications the electronic functions of said SIL unit can be protected against humidity or mechanical damage by an appropriate coating such as an epoxy resin or a phenolic resin. Fig. 2 shows a configuration of a SIL circuit having straight lead terminals **5**. A variation often used in electronics is the so-called snap-in leadform of the terminals **6**, as shown in Fig. 3. Snap-in leads have the advantage over straight leads that they guarantee that the circuits are mechanically fixed in the positioning holes of the printed circuit board assembly at insertion and that a correct snap-off of the electronic circuit is always respected.

Having reference to Fig. 4 a basic packaging system of this invention designated generally by the numeral **10** is shown in a horizontal planar orientation as would be appropriate for either the filling of the tape with the SIL circuits or for subsequent removal of said SIL circuits from the tape.

The basic embodiment as shown in Fig. 4 comprises a carrier tape **11** and an adhesive tape **12.** The carrier tape **11** is formed from a strip of a suitable paper material having appropriate characteristics of flexibility and structural strength. It is of a width that is sufficient to accommodate the length of the particular electronic SIL circuits that are to be packaged therein, and has a sufficient thickness in order to provide the necessary structural rigidity during transport movements, but still enables mechanical manipulation by the assembly equipment. The adhesive tape **12** is from a high grade, printable saturated paper backing coated with a specially formulated latex pressure sensitive adhesive system. It exhibits adequate structural strength and resilient flexibility to enable assembly with the carrier tape **11.**

In order to perform the function of positioning the SIL units on the carrier tape **11,** the tape is formed with a plurality of holes **13** in a predetermined grid pattern that is perfectly matched to the number of lead terminals on said SIL electronic circuit. These holes **13** are dimensioned to receive these lead terminals with those leads thus projecting through the carrier tape.

Obviously, forming of a grid pattern of the holes **13** enables any SIL unit physical outlook to be located at the desired relative position on the packaging system of this invention. It will also be understood that the grid holes **13** may be modified in accordance with the specifications for a particular SIL circuit destinated to be packaged in the packaging system of this invention.

Having reference to Fig. 5 the grid holes **13** may incorporate an additional cut **15** in order to facilitate the unloading of SIL electronic circuits with snap-in lead forms.

Both the carrier tape **11** and the adhesive tape **12** are manufactured from low cost basic materials that offer the exceptional advantage of being totally biodegradable. Compared to the prior art, the packaging system of this invention thus provides an environmentally safe and friendly operation.

It will be understood that the width of the carrier tape **11** and the adhesive tape **12** are determined by the physical dimension of the SIL units to be packaged. However, it is desirable that the packaging system will be fabricated in several standardized width sizes that are matched to the various types of automated machinery with which the packaging system may be used. The pressure sensitive adhesive system employed in the adhesive tape **12** serves to locate the protruding lead terminals firmly to the adhesive tape **12** thereby ensuring retention of the SIL circuits in the packaging system of this invention.

Assembly of the adhesive tape **12** with the carrier tape **11** can be accomplished by a relatively simple technique. The SIL circuits will first be placed on the carrier tape **11** with their respective lead terminals inserted in the holes **13** of said carrier tape **11** and thus fixed in position on the surface of the carrier tape. Once this has been accomplished the adhesive tape **12** may then be applied to the backside of said carrier tape using a specifically dedicated tool that exercises a transversal pressure to said adhesive tape. Disassembly of the adhesive tape from the carrier tape can be affected by a simple movement of pulling the adhesive tape in a reverse relationship to itself. Evidently these concepts can easily be integrated into the design of an automated tape and reel machine suited for the packaging system of this invention.

To further enhance the usefulness and capabilities of this packaging system, the system of the invention is provided with indexing means through formation of a series of longitudinally spaced indexing holes **14** which, if desired, may be located at each marginal edge of the carrier tape **11.** These indexing holes **14** are designed to interfit with the sprocket wheels of either the mechanisms for assembly of said packaging system with SIL circuits or the unloading of those circuits from the packaging system or any other mechanism operating with said packaging system. These indexing holes **14** are located in the carrier tape such that they will be oriented in specific dimensional relationship to the grid holes **13** so that it is possible by means of such indexing holes to either precisely locate the carrier tape **11** at a SIL loading station or precisely locate said carrier tape at a SIL unloading station.

With the indexing holes **14** located in predetermined relationship with respect to the grid holes **13,** it is assured that other mechanisms will be capable of positioning the SIL circuits in the locating means or to remove them from that position for subsequent use in automated systems. In using the tape indexing means in conjunction with the loading of the circuits, it will be noted that the carrier tape **11** may thus be positively fixed during those sequential operations wherein an equipment may mechanically load the circuits onto the carrier tape and a mechanical tool can automatically perform assembly of the bonding and carrier tapes. Although indexing holes **14** are illustrated, it will be understood that other indexing means may be utilized.

Having thus described the packaging system of this invention, the functioning of same packaging system **10** to enable insertion of SIL electronic circuits and subsequent reel taping is diagrammatically illustrated in Fig. 6. On the one end of the insertion apparatus, the carrier tape **11** is mechanically advanced to the area where the SIL circuits are to be inserted by means of the sprocket wheel **20**. The sprocket pins on said sprocket wheel are of a configuration and size to cooperatively project through the respective sprocket holes **14** and to effect longitudinal displacement of the carrier tape. At the insertion station **31** the single-in-line electronic circuit is vertically plugged using its lead terminal pins into the grid holes **13** of the carrier tape **11**. Upon advancement of the carrier tape after insertion of the SIL unit, a specifically designed tool **23** of the insertion apparatus forces said SIL unit to be tilted to its side **32,** with the lead terminals remaining however in the grid holes **13.** Simultaneously with this operation, the adhesive tape **12** is presented between the underside of the carrier tape **11** and a mechanical tool **24.** Said adhesive tape **12** is unrolled from a reel **21** of adhesive tape material and driven forward to the insertion area of the equipment by means of a driving wheel **22.** Said adhesive tape is then further guided over the mechanical tool **24** of the insertion equipment.

Simultaneously with the above described tilting operation of the SIL circuit the tool **24** exerts a pressure force on the bottom side of the adhesive, thereby securely fixing the lead terminals of the SIL circuit to the carrier tape.

Upon further advancing the carrier tape to the right side of the insertion equipment, the assembled packaging system is further deviated to position **33** whereafter the SIL circuits are forced to lie almost in a horizontal position with respect to said carrier tape. At the end of the insertion operation said SIL electronic circuits are wound on a reel **25** using techniques and materials which are well known to those skilled in the art.

A more detailed perspective view along plane A-A in Fig. 4 is presented in Fig. 7 and illustrates the different characteristics of the assembled packaging system of this invention.

The SIL electronic circuit 1 has an inclined position with respect to the carrier tape **11** and the connecting pins or lead terminals of said circuit are securely fixed to said carrier tape by means of the adhesive tape **12,** whereby it can be clearly seen that the interconnection between carrier tape and bonding tape takes place at the location between two ranges of grid holes **13** and on the underside of said carrier tape.

A completely assembled reel **25** of the SIL circuits, using the packaging system of this invention, is illustrated in Fig. 8. Such reels are completely compatible with the mechanics of automated pick and place machinery and will not be described here further since these mechanical concepts are well known to those skilled in this particular art.

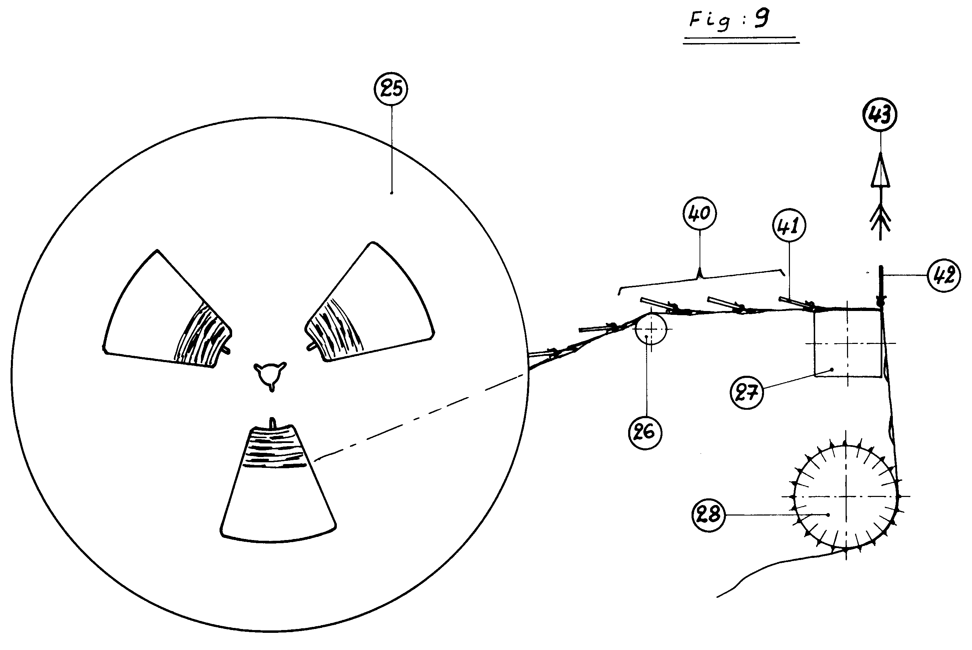

Unloading of the assembled SIL circuits using the packaging system of this invention is schematically illustrated in Fig. 9. The reel **25** with said SIL circuits is unreeled using mechanical tools which are well known to those skilled in the art, and will not be described in this disclosure. The unreeled tape is then advanced over a guiding wheel **26** of an adequate feeder unit **40.** A specifically designed square shaped mechanical tool **27** of said feeder unit **40** is employed to bring the SIL circuits again from their quasi horizontal position **41** on the reel tape to the vertical position **42** at the pick and place station **43** of the automated assembly machinery, said pick and place station being the workstation where the SIL circuits are unloaded from the tape and subsequently placed in the through-holes of the printed circuit board. Said feeder unit thus being specifically designed for enabling a vertical distribution of said SIL circuits at the pick and place station, it is obvious that the pick up of said SIL units may be achieved either by automatic or manual pick up. In the vertical position said circuits can be easily removed from the packaging system with very little force. The empty packaging system is then sorted out of the machine using a sprocket wheel mechanism **28.**

In describing the packaging system embodying this invention, the carrier and bonding tapes were generally described as being fabricated from paper type materials exhibiting the requisite structural strength and flexible characteristic. In this way an environmentally friendly packaging system is provided to the users. However, materials other than paper such as for example synthetic resins or plastics may be utilized in fabrication of either or both carrier tape and bonding tape.

The several embodiments of the packaging system of this invention have been illustrated and described as having only one row of assembled circuits between any two adjacent points of interconnection between the carrier tape and the bonding tape. However, this basic configuration is not to be considered limitative as to the practice of this invention.

It will be apparent from the above description of the different embodiments of this invention that a novel packaging system has been provided for fulfilling the requirements of fully automated component handling systems. The described packaging system performs a basic packaging function but more importantly, performs a packaging function in which each of the packaged circuits is precisely positioned in a predetermined orientation, so that they can be readily handled by automated machine mechanisms throughout a manufacturing process including ultimate utilization of the circuits, but also transportation and storage or other functions.

The packaging system provided by this invention is also capable of modification to accommodate variously configured circuits while retaining the ability to implement the invention as defined in the claims.

## Claims

1. A tape and reel packaging system for single-in-line (SIL) electronic circuits disposed seriatim in predetermined relationship, consisting of
(a) a primary package and
(b) a secondary package,
whereby the primary package comprises a carrier tape **11** and an adhesive tape **12** combined in such a way that said SIL circuits **1** are positioned almost horizontally in the secondary package, thereby ensuring the maximum packaging density of the secondary package and an effective protection against lead damage or deterioration of lead coplanarity,
(1) said carrier tape **11**, consisting of a strip of suitable paper material or for example synthetic resins or plastics material having appropriate characteristics of flexibility and structural strength, having a plurality of locating through-holes **13** in a predetermined grid pattern disposed seriatim along a longitudinal axis of said carrier tape **11** in spaced relationship, each of said locating through-holes **13** designed to cooperatively engage with at least one SIL circuit **1** by protrusion of its lead terminals **4** in order to releasable position that SIL circuit 1 in a predetermined location and orientation with respect of said carrier tape **11,** said carrier tape **11** also being provided with a series of longitudinally spaced indexing holes **14** at each marginal edge and located in a predetermined relationship to said locating through-holes **13,** thereby assuring precise positioning of said carrier tape **11** at a loading or unloading station for said SIL circuits **1,**
(2) said adhesive tape **12,** consisting of a high grade paper backing or for example synthetic resins or plastics material coated with a specially formulated pressure sensitive adhesive system, disposed in longitudinally extending relationship to said carrier tape **11** and overlying the lead terminals **4** of said SIL circuits **1** protruding to said locating through-holes **13** of said carrier tape **11,** and wherein the secondary package is a reel **25** carrying the primary package with the single-in-line circuits **1.**

2. A tape and reel packaging system according to claim **1** wherein said single-in-line electronic circuits **1** have either straight lead terminals **5** or snap-in formed lead terminal **6.**

3. A tape and reel packaging system according to claim 2 wherein for one SIL circuit **1** the number of said lead terminals can vary from 2 to n, n being an integer number higher than 2.

4. A tape and reel packaging system according to claim 1 wherein each of said article locating through-holes **13** may incorporate an additional cut **15** thereby facilitating the unloading of said SIL circuits **1.**

5. A tape manipulating apparatus for producing the packaging system according to claim 1, comprising
(1) a specifically designed mechanical tool **23** for tilting the vertically inserted SIL circuits **1** from an upright to an almost horizontal position in said carrier tape **11,** with the lead terminals **4** remaining however in the locating through-holes **13,** and also comprising thereafter
(2) a specifically designed mechanical tool **24** exerting a pressure force on the bottom of said adhesive tape **12,** thereby securely fixing the lead terminals of said SIL circuit **1** to said carrier tape **11** and assuring said SIL circuits **1** to remain firmly positioned horizontally with respect to the combination of carrier tape **11** and adhesive tape **12** in the assembled reel **25,** thereby ensuring optimum packaging density and protection of the SIL circuits **1** against lead damage.

6. A tape manipulating apparatus for unloading the packaging system according to claim 1, comprising a feeder unit **40** comprising a specifically designed square-shaped mechanical tool **27** around part of which the primary package is guided to force said horizontally packaged SIL circuits **1** back from their almost horizontal position to a perfectly vertical position at the unloading station for said SIL circuits **1** from said tape packaging system, thereby assuring perfect vertical placement of said SIL circuits **1** in the corresponding through-holes of the printed circuit boards.

7. A tape and reel packaging system according to claim 1 having one or more rows of assembled single-in-line circuits 1 between any two adjacent points of interconnection between said carrier tape **11** and said adhesive tape **12.**

## Patentansprüche

1. Ein Gurtungsverpackungssystem für elektronische Schaltungen mit den Drähten auf einer Seite (SIL), welche in bestimmter Reihenfolge positioniert sind, und bestehend aus:
(a) einer primären Verpackung und
(b) einer sekundären Verpackung,
wo die primäre Verpackung aus einem Tragerband **11** und einem Klebeband **12** besteht, welche so kombiniert sind daß die vorgenannten SIL Schaltungen **1** fast horizontal in der sekundären Verpackung eingeordnet werden, wodurch eine maximale Verpackungsdichtheit der sekundären Verpackung, sowie ein effizienter Schutz gegen Beschädigung der Drähte oder Vernichtung der Koplanarität der Drähte garantiert wird.
(1) vorgenanntes Trägerband **11,** welches aus einem geeigneten Streifen Papier oder, zum Beispiel, aus synthetischem Harz oder plastischem Material besteht, welches die geeigneten Eigenschaften von Beweglichkeit und struktureller Stärke besitzt, versehen mit einer Vielfalt Positionierungslöchern **13** die, in einem bestimmten Raster, auf Abstand und in Reinenfolge der Längsachse des vorgenannten Trägerbandes **11** entlang aufeinander folgend angeordnet sind, jedes dieser vorgenannten Positionierungslöcher **13** so entworfen um mit mindestens einer SIL Schaltung **1** durch deren herausragende Drahtausgänge **4** zusammenzukommen, um die Schaltung **1** freizugeben und in einer bestimmten Position und Orientierung im Verhältnis zum Trägerband **11** zu positionieren, vorgenanntes Trägerband **11** ist auch längswärts an jedem Randende versehen mit einer Serie in Anständen aufeinanderfolgenden Indexlöchern **14** welche sich in einem bestimmten Verhältnis zu den vorgenannten Positionierungslöchern **13** befinden, wodurch präzise Positionierung des vorgenannten Trägerbandes **11** bei der Lade und Ablade Station für die vorgenannten SIL Schaltungen **1** versichert wird,
(2) vorgenanntes Klebeband **12,** welches aus einem leistungsfähigen Papierhintergrund besteht, oder zum Beispiel, aus synthetischem Harz oder plastischem Material welches durch eine speziell entworfene druckempfindliche Haftschicht bedeckt ist, der Länge nach im Verhältnis zum vorgenannten Trägerband **11** positioniert und über den Drahtausgängen **4** der vorgenannten SIL Schaltungen **1** liegend, durch die vorgenannten Positionierungslöcher **13** des vorgenannten Trägerbandes **11** herausragend und wo die sekundäre Verpackung aus einer Rolle **25** besteht welche die primäre Verpackung mit den SIL Schaltungen **1** enthält.

2. Ein Gurtungsverpackungssystem nach Anspruch 1 wo die vorgenannten SIL elektronischen Schaltungen **1** entweder aus geraden Drahtausgängen **5** oder aus snap-in geformten Drahtausgängen **6** bestehen.

3. Ein Gurtungsverpackungssystem nach Anspruch 2 wo für eine SIL Schaltung **1** die Anzahl der vorgenannten Drahtausgänge von 2 bis n reichen kann, wo n eine Ziffer größer als 2 ist.

4. Ein Gurtungsverpackungssystem nach Anspruch 1 wo jedes der vorgenannten Artikelpositionierungslöcher **13** einen beikommenden Schnitt **15** enthält, wodurch die Abladung der vorgenannten SIL Schaltungen **1** erleichtert wird.

5. Eine Bandbehandlungsapparatur zur Fertigung des Verpackungssystems nach Anspruch 1, bestehend aus:
(1) einem speziell entworfenen Werkzeug **23** um die vertikal eingegebenen SIL Schaltungen **1** von einer stehenden Position zu einer fast liegenden Position im vorgenannten Trägerband **11** zu bringen, wobei die Drahtausgänge **4** jedoch in den Positionierungslöchern **13** bleiben, und auch bestehend aus
(2) einem speziell entworfenen Werkzeug **24** welches einen Druck ausübt auf den unteren Teil des vorgenannten Klebebandes **12,** wodurch die Ausgangsdrähte der SIL Schaltungen sicher mit dem vorgenannten Trägerband **11** verbunden werden, wodurch gewährleistet wird daß die vorgenannten SIL Schaltungen **1** horizontal im Verhältnis zur Kombination Trägerband **11** -Klebeband **12** in der zusammengebauten Rolle **25** positioniert bleiben, wobei optimale Verpackungsdichtheit und Schutz gegen Drahtbeschädigung der SIL Schaltungen **1** garantiert wird.

6. Eine Bandbehandlungsapparatur zur Entladung des Verpackungssystems nach Anspruch 1, welche eine Anbringungseinheit **40** umfasst, die ein speziell entworfenes, viereckiges mechanisches Werkzeug **27** enthält rund welches ein Teil der primären Verpackung geleitet wird, um die vorgenannten horizontal verpackten SIL Schaltungen **1** von ihren fast horizontalen Position in eine perfekt vertikale Position zu zwingen an der Entladungsstation der vorgenannten SIL Schaltungen **1** des vorgenannten Gurtungsverpackungssystems, wobei eine perfekt vertikale Position der vorgenannten SIL Schaltungen **1** in den übereinstimmenden Positionierungslöcher der gedruckten Schaltungen versichert wird.

7. Ein Gurtungsverpackungssystem nach Anspruch 1 welches eine oder mehrere Reihen zusammengebauter SIL Schaltungen **1** besitzt zwischenjeden zwei angrenzenden Verbindungspunkte zwischen vorgenanntem Trägerband **11** und vorgenanntem Klebeband **12.**

## Revendications

1. Un système d'emballage sur bande et rouleau pour des circuits électroniques avec des fils de sortie d'un côté (SIL) disposés successivement en relation prédéterminée, se composant
(a) d'un emballage primaire et
(b) d'un emballage secondaire,
dont l'emballage primaire comprend une bande de support **11** et une bande adhésive **12** combinées de façon que les circuits SIL **1** précités sont positionnés presque horizontalement dans l'emballage secondaire, assurant ainsi une densité d'emballage maximale de l'emballage secondaire et une protection effective contre l'endommagement des terminaux ou la détérioration de la coplanarité des terminaux,
(1) la bande de support **11** précitèe, se composant d'une bande de papier convenable ou, par exemple, de résines synthetiques ou d'un matériel plastique avec des caractéristiques de flexibilité et de force structurelle adèquates, ayant une multitude de trous de positionnement **13** dans une configuration prèdétèrminée en grille disposés espacés et successivement le long de l'axe longitudinale de la bande de support **11,** chacun des trous de positionnement **13** dessinés afin de s'engager entièrement avec au moins un circuit SIL **1** par dépassement de ses terminaux **4** afin de librement positionner ce circuit SIL **1** à un emplacement prédéterminé et orienté par rapport à la bande de support **11,** la bande de support **11** précitée étant également pourvu d'une série de trous d'indexation espacés en longueur **14** à chaque extrémité marginale et disposés en relation predéterminée par rapport aux trous de positionnement **13**, assurant ainsi le positionnement précis de la bande de support **11** précitée à la station de chargement ou de déchargement pour les circuits SIL **1** précités,
(2) la bande adhésive **12** précitée, consistent d'un support en papier de haute qualité ou, par exemple, de résines synthétiques ou d'un matériel plastique, recouvert d'une couche d'un système adhésif sensible à la pression spécialement conçu, disposé en relation longitudinale par rapport à la bande de support **11** et recouvrant les terminaux **4** des circuits SIL **1** précités, dépassant par les trous de positionnement **13** précités de la bande de support **11** prècitèe, et dont l'emballage secondaire est un rouleau **25** portant l'emballage primaire avec les circuits SIL **1.**

2. Un système d'emballage sur bande et rouleau selon la revendication l où les circuits électroniques SIL **1** prècités, ont soit des terminaux droits **5** soit des terminaux formés en snap-in **6.**

3. Un système d'emballage sur bande et rouleau selon la revendication 2 où pour un circuit électronique SIL **1** le nombre des terminaux précités peut varier de 2 à n, n étant un chiffre intègre supérieur à 2.

4. Un système d'emballage sur bande et rouleau selon la revendication 1 où chacun des trous de positionnement de Particle **13** prècités peut contenir une coupure additionnelle **15** facilitant ainsi le déchargement des circuits SIL **1** précités.

5. Un èquipement de manipulation de bande pour produire le système d'emballage selon la revendication 1 comprenant
(1) un outil mécanique **23** spécialement conçue pour basculer les circuits SIL **1** insérés verticalement d'une position droite vers une position presque horizontale dans la bande de support **11** précitée, les terminaux 4 restants toutefois dans les trous de positionnement **13,** et comprenant également
(2) un outil mécanique **24** spécialement conçue pour exercer une pression sur le bas de la bande adhésive **12,** de façon à fixer ainsi solidement les terminaux du circuit SIL **1** précité de la bande de support **11** et assurant ainsi que les circuits SIL **1** précités, restent positionnés fermement horizontals par rapport à la combinaison de la bande de support **11** et la bande adhésive **12** dans le rouleau assemblé **25,** assurant ainsi une densité d'emballage optimale et une protection des circuits SIL **1** contre l'endommagement des terminaux.

6. Un équipement de manipulation de bande pour décharger le système d'emballage selon la revendication 1, comprenant une unité d'alimentation **40** comprenant un outil mécanique spécialement conçu en forme carré **27** autour duquel une partie de l'emballage primaire est guidée afin de forcer les circuits SIL **1** précités placés horizontalement, de leur position presque horizontale vers une position parfaitement verticale à la station de dèchargement pour les circuits SIL **1** précités du système d'emballage sur bande précité, assurant ainsi un placement parfaitement vertical des circuits SIL **1** précités dans les trous de positionnement correspondants des circuits imprimés.

7. Un système d'emballage sur bande et rouleau selon la revendication 1 ayant une ou plus de rangés de circuits SIL **1** assemblés entre n'importe lequel de deux points adjacents d'interconnexion entre la bande de support **11** et la bande adhésive **12.**
